# EUROPEAN PATENT SPECIFICATION

(11) **EP 2 434 645 B1**
(45) Date of publication and mention of the grant of the patent: **11.03.2020**
(21) Application number: 10180959.8
(22) Date of filing: 28.09.2010
(51) Int. Cl.: G06F 3/02, H03K 17/975, H03K 17/96

(54) **A multi action capacitive switch and methods of use**
Multiaktionskapazitätsschalter und Verwendungsverfahren
Commutateur capacitif multi-action et procédés d'utilisation

(43) Date of publication of application: 28.03.2012
(73) Proprietor: BlackBerry Limited, Waterloo, ON N2K 0A7 (CA)
(72) Inventor: Lee, Yun Sun, Rolling Meadows, IL 60008 (US); Hsu, Chin Feng, Rolling Meadows, IL 60008 (US)
(74) Representative: Vigand, Philippe

(56) References cited:
- EP-A2- 1 081 922
- WO-A1-2011/003555
- US-A1- 2006 113 178
- US-A1- 2009 008 234
- US-A1- 2009 128 511
- US-A1- 2009 135 144

## Description

### Field

This disclosure relates generally to handheld electronic devices and, more particularly, to a handheld electronic device including a capacitive switch and methods for employing the capacitive switch.

### Background Information

Numerous types of handheld electronic devices are known. Examples of such handheld electronic devices include, for instance, personal data assistants (PDAs), handheld computers, two-way pagers; cellular telephones, digital cameras, and the like. Although some handheld electronic devices are stand-alone devices, many feature wireless communication capability for communication with other devices.

Handheld electronic devices are generally intended to be portable, and thus are of a relatively compact configuration in which input structures such as keys may perform multiple functions under certain circumstances or may otherwise have multiple aspects or features assigned thereto. With advances in technology, handheld electronic devices are built to have progressively smaller form factors yet have progressively greater numbers of applications and features resident thereon. As a practical matter, the keys of a keypad can only be reduced to a certain small size before the keys become relatively unusable. Furthermore, due to the limited number of keys and the increasing number of features available on the device, access to these features may be buried under multiple layers of menus making use of the features cumbersome.

Many handheld electronic devices use mechanical keys that allow a user to feel the actuation of a key. Users feel comfortable with the feel of these keys and device manufacturers have spent large amounts of money to design and implement production lines to produce these keys. Many users would not want to switch to a key displayed as part of a touch screen and manufacturers would not be willing to make large scale changes to production lines to accommodate widely divergent mechanical keys.

### SUMMARY

The invention is defined by the appended claims.

### BRIEF DESCRIPTION OF THE DRAWINGS

The accompanying drawings, which are incorporated in and constitute a part of this specification, illustrate several embodiments and, together with the description, serve to explain the disclosed principles. In the drawings:
Figure 1 is a top plan view of an improved handheld electronic device, consistent with disclosed embodiments;
Figure 2 is a schematic depiction of the handheld electronic device of Figure 1;
Figure 3 is an exemplary capacitive switch, consistent with disclosed embodiments.
Figure 4 is an exemplary capacitive switch detecting a touch, consistent with disclosed embodiments;
Figure 5 is an exemplary capacitive switch during actuation, consistent with disclosed embodiments;
Figure 6 is an exemplary flowchart illustrating the implementation of a multi-action capacitive switch, consistent with disclosed embodiments.
Figure 7 is an exemplary default output of an improved handheld electronic device, consistent with disclosed embodiments;
Figure 8 is an exemplary output of an improved handheld electronic device after detection of a capacitance change at a capacitive switch, consistent with disclosed embodiments;
Figure 9 is an exemplary output of an improved handheld electronic device after detection of a tap of a capacitive switch, consistent with disclosed embodiments.

### DETAILED DESCRIPTION

Disclosed embodiments provide a multi-action capacitive switch device that a handheld electronic device may employ as a key or other button. In one exemplary embodiment, the multi-action switch comprises a surface with a capacitive sensing area and a plunger comprising a conductive path. The conductive path of the plunger is in contact with the capacitive sensing area so that a change in capacitance sensed by the capacitive sensing area is transferred down the conductive path. The device may further include a structure fabricated from flexible conductive material in contact with the conductive path of the plunger. The structure, which may be dome-shaped, contacts a capacitive touch detector and, when the switch is actuated by a user, the plunger causes the structure to contact an actuation detection detector.

In other disclosed embodiments, a method is provided for placing a phone call using a mobile communication device, the mobile communication device comprising an input apparatus, an output apparatus, a memory, and a processor, and the input apparatus comprising a plurality of keys, at least one of which comprises a capacitive switch input member. The method includes detecting a change in capacitance at the input member. The method further includes, in response to detecting the capacitance change, causing the output apparatus to display a plurality of phone numbers, wherein one of the plurality of phone numbers is marked for selection. The method may further include detecting an actuation of the input member and, in response, causing the mobile communication device to place a call to the one of the plurality of phone numbers marked for selection.

Consistent with other disclosed embodiments, a method of using a capacitive switch in a handheld device is provided. The handheld device includes a camera, an input apparatus, an output apparatus, a memory, and a processor, and the input apparatus comprises a capacitive switch input member. The method includes detecting a capacitance change at the capacitive switch input member and, in response, causing the camera to initiate a focus function. The method may further include detecting an actuation of the capacitive switch input member causing the camera to take a picture.

It is to be understood that both the foregoing general description and the following detailed description are exemplary and explanatory only and are not restrictive of the disclosed embodiments, as claimed.

Reference will now be made in detail to exemplary embodiments, examples of which are illustrated in the accompanying drawings. Wherever convenient, the same reference numbers will be used throughout the drawings to refer to the same or like parts.

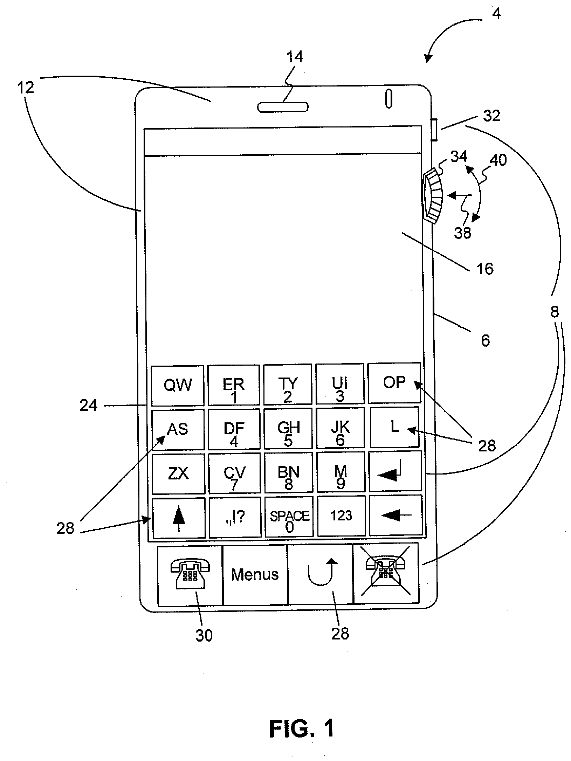

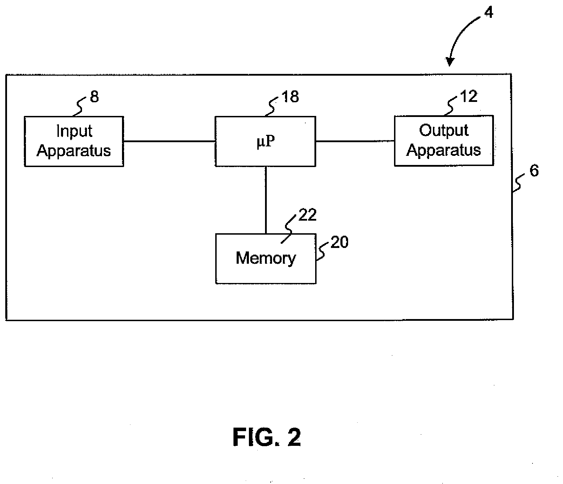

A handheld electronic device 4 is indicated generally in Figure 1 and is depicted schematically in Figure 2. Exemplary handheld electronic device 4 may include housing 6 in which is disposed a processor unit that may include input apparatus 8, output apparatus 12, processor 18, and memory 20 for storing at least routine 22. Processor 18 may be, for instance, and without limitation, a microprocessor (µP) and may be responsive to input signals from input apparatus 8 and may provide output signals to output apparatus 12. Processor 18 may also interface with memory 20 and may be capable of executing routine 22. Examples of handheld electronic devices are included in U.S. Patent No. 6,452,588, U.S. Patent No. 6,873,317, and U.S. Patent No. 6,489,950. US 2009/0135144 describes an input module for an electronic device including a key and a touch sensing unit.

As can be understood from Fig. 1, output apparatus 12 may include display 16 and speaker 14, each of which may be responsive to one or more output signals from processor 18. Input apparatus 8 may include keypad 24, button 32, and scroll wheel 34. Keypad 24 is in the exemplary form of a QWERTY keyboard including a plurality of keys 28 that serve as input members. Keys 28 are disposed on a front face of housing 6, and button 32 may be disposed at a side of housing 6. Button 32 can serve as another input member providing input to processor 18. Scroll wheel 34 may be a rotatable thumbwheel that provides other input to processor 18. For example, scroll wheel 34 may provide one input to processor 18 when rotated in the direction represented by arrow 40 and a second input to processor 18 when actuated in the direction represented by arrow 38. Scroll wheel 34 may also be a ball or an optical trackpad and may be located on the face of handheld electronic device 4.

A number of keys 28 or other input members may function as a multi-action switches, such as key 30 and button 32. As employed herein, the expression "a number of" and variations thereof shall refer broadly to any non-zero quantity, including a quantity of one. Generally speaking, the handheld electronic device 4 is structured such that the processor 18 recognizes a different input from input members functioning as a multi-action switch, such as key 30, based on whether a user is touching the key, actuating the key, or tapping the key. For example, when a user desires to make a phone call, the user may place a finger on key 30. Processor 18 may be instructed to display a list of phone numbers in response to this input. When the user actuates key 30, processor 18 may be instructed to place a call to one of the phone numbers.

Memory 20 can be any one or more of a variety of types of internal or external storage media such as, without limitation, RAM, ROM, EPROM(s), EEPROM(s), and the like that provide a storage register for data storage such as in the fashion of an internal storage area of a computer, and can be volatile memory or nonvolatile memory. Memory 20 may include a number of routines depicted generally with the numeral 22 for the processing of data. The routines 22 can be in any of a variety of forms such as, without limitation, software, firmware, and the like. As will be explained in greater detail below, the routines 22 may include a camera application, a phone book application, as well as other routines.

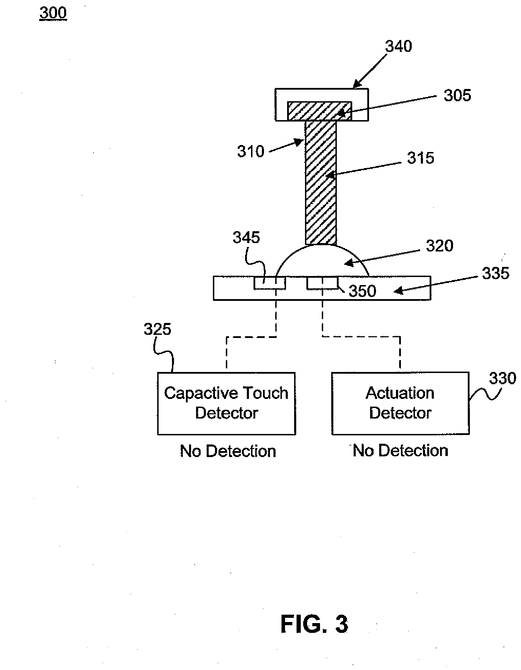

Figure 3 is an exemplary capacitive switch 300, consistent with disclosed embodiments. Capacitive switch 300 makes novel improvements on mechanical actuation input devices, such as key 30 and button 30 of Figure 1, providing a cost-effective switch capable of producing multiple inputs with a minimal number of components. As shown in Figure 3, switch 300 includes surface 340 with capacitive sensing area 305. Surface 340 may be a key face, a button, a pad, or other surface identifying the switch. Capacitive sensing area 305 may include any conductive material. Examples include, but are not limited to, metals such as silver and copper, graphite, anti-static conductive foam, and plasmas. Surface 340 and capacitive sensing area 305 may be connected to plunger 310. In certain embodiments plunger 310 may be one piece comprised of conductive path 315. In other embodiments plunger 310 may have a non-conductive material housing conductive path 315. Conductive path 315 may be made from any of the conductive materials described above. Conductive path 315 may be made of the same material as capacitive sensing area 305 or it may be made of a different material. In some embodiments, capacitive sensing area 305 and conductive path 315 may comprise a single molded piece made of a single conductive material.

Conductive path 315 may transmit a change in capacitance sensed by area 305 to flexible structure 320. Structure 320 is shown in Figure 3 as having a dome configuration, although other configurations may be possible including, but not limited to, an arch, a flattened cone, or a box. Structure 320 may be constructed of any flexible conductive material. For example, structure 320 may be metal or structure 320 may be another flexible material coated with metal. Structure 320 may contact conductive path 315 and capacitive touch detector 325. Capacitive touch detector 325 may be implemented using an integrated circuit, discrete circuitry, an A/D converter, a processor input port etc. In some embodiments, structure 320 may contact capacitive touch detector 325 through pad 345. Pad 345 may include a button, pad, or other switch that detects the collapse of structure 320. In other embodiments, structure 320 may sit atop a ring of conductive material (not shown). The ring may enable structure 320 to transmit a change in capacitance to detector 325. Capacitive touch detector 325 may be located on or connected to printed circuit board 335 and may receive and process a change in capacitance transferred from sensing area 305.

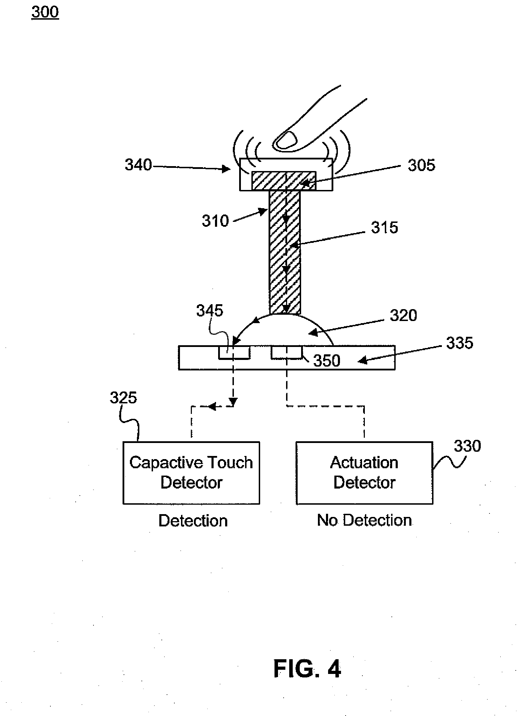

Switch 300 may also include actuation detector 330. Actuation detector 325 may be implemented using an integrated circuit, discrete circuitry, an A/D converter, a processor input port etc. When plunger 310 causes structure 320 to collapse, structure 320 may connect with actuation detector 330, thus completing an electrical circuit. In some embodiments, structure 320 may connect with actuation detector 330 through pad 350. Pad 350 may include a button, pad, or other switch that detects the collapse of structure 320. Alternatively, the inside of structure 320 may sit atop a portion of printed circuit board 335 that has an interleaving comb pattern. When plunger 310 causes structure 320 to collapse, structure 320 may make contact with the interleaving comb pattern causing actuation detector 330 to detect the collapse. Actuation detector 330 may be located on or connected to printed circuit board 335 and may receive and process the actuation of structure 320. It should be noted that although actuation detector 330 and capacitive touch detector 325 are shown in Figure 4 as separate detectors, the functionality of these devices may be implemented as a single integrated circuit or may be incorporated into an integrated circuit containing additional functions, such as but not limited to, processor 18.

Figure 4 is an exemplary capacitive switch detecting a touch, consistent with disclosed embodiments. For example, because a finger is conductive, when the user's finger or other body part comes close to or touches surface 340 of the switch, capacitive sensing area 305 may detect a change in capacitance due to the presence of the finger. The change in capacitance may travel through conductive material 315, down to structure 320, finally being transmitted to capacitive touch detector 325. Capacitive touch detector 325 may contain circuitry that determines whether the change in capacitance received from structure 320 is large enough to qualify as a user's finger coming near or touching surface area 340 of switch 300. If the change in capacitance is large enough to constitute a touch of switch 300, capacitive touch detector 325 may communicate this as an input to processor 18. Processor 18 may be structured to run a function in routine 22 when it receives the capacitive touch input.

In certain disclosed embodiments, when the change in capacitance is large enough to constitute a touch, processor 18 may determine the length of the touch. For example, processor 18 may treat a short touch, such as a tap, as one type of input and may treat a longer touch as a different type of input. In other embodiments, capacitive touch detector 325 may contain circuitry that determines the length of the touch and sends an indication of a first type of input to processor 18 for a touch and an indication of a second type of input to processor 18 for a shorter tap.

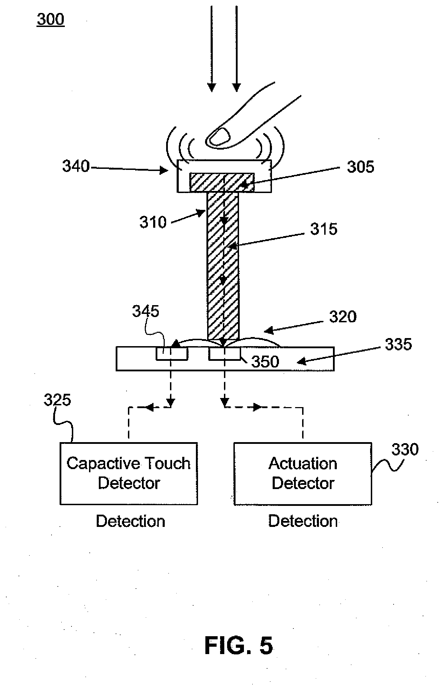

Figure 5 is an exemplary dual action switch during actuation, consistent with disclosed embodiments. When a user presses down on surface area 340, plunger 310 may cause structure 320 to collapse, actuating switch 300. When collapsed, structure 320 may contact actuation detector 330. Detector 330 may communicate connection with structure 320 directly to processor 18 as an actuation input. Thus, processor 18 may receive a third input from switch 300. In certain disclosed embodiments, processor 18 may only recognize an actuation of switch 300 when it receives an capacitive touch input from detector 325 and an actuation input from detector 330. In this manner, processor 18 may ignore an accidental actuation of switch 300, for example, when a pen in a briefcase or a purse accidently actuates the key.

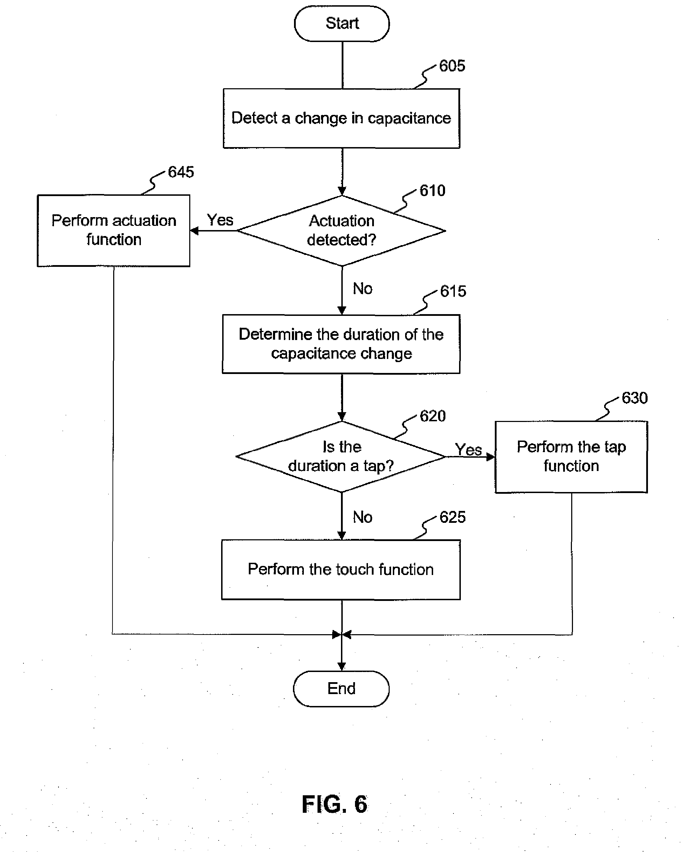

Figure 6 is an exemplary flowchart of the implementation of a multi-action capacitive switch, consistent with disclosed embodiments. The flowchart demonstrates how capacitive switch 300 may initiate three distinct functions using processor 18. The flowchart may be called from a function that waits for user input and would return to the wait state after completion. In step 605, capacitive touch detector 325 may detect a change in capacitance caused, for example, by a user touching surface 340. Next, processor 18 may determine that no actuation of switch 300 has occurred (step 610, No). In step 615, processor 18 may determine the duration of the capacitance change. In alternate embodiments, capacitive touch detector 325 may determine the duration and send the duration to processor 18. If the duration is longer than a tap (step 620, No), then in step 625, processor 18 may initiate a touch function. A touch function may, for example, cause a list of phone numbers to be displayed by an output apparatus, or may focus a picture, but may also include any other function suitable for detection of a touch input at capacitive switch 300.

If the duration is short enough to qualify as a tap (step 620, Yes), then in step 630, processor 18 may initiate a tap function. A tap function may be changing the item marked for selection in a list of items, turning a flash on or off, but can be any other function suitable for detection of a tap input. If processor 18 detects an actuation of capacitive switch 300 after detecting the change in capacitance (step 610, Yes), then processor 18 may perform an actuation function. An actuation function may be calling a selected phone number, taking a picture, or any other function suitable for detection of an actuation input at capacitive switch 300. Figure 6 indicates processor 18 would not recognize an actuation of capacitive switch 300 without detecting a change in capacitance. However, disclosed embodiments are not limited to any particular order. In some embodiments, an actuation of switch 300 may be detected regardless of detecting an associated change in capacitance. In other embodiments, processor 18 may not perform the actuation function until after performance of the touch function.

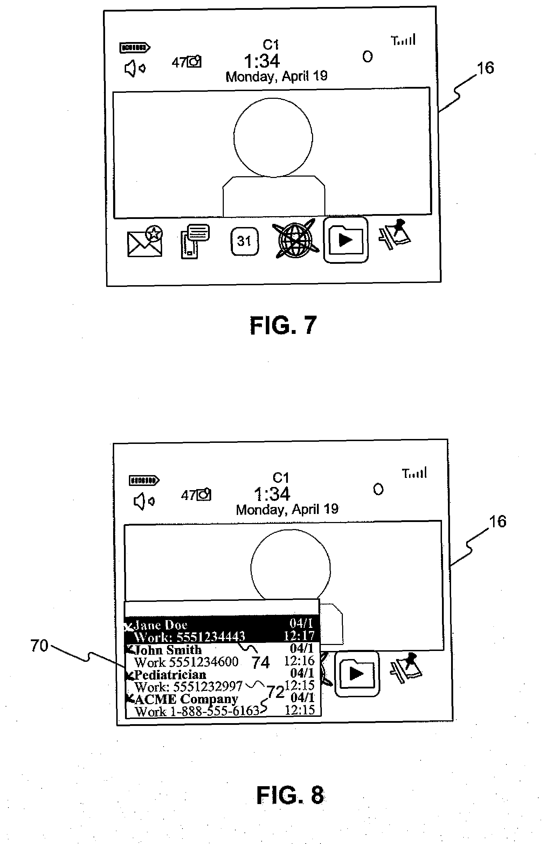

An exemplary method of using a capacitive switch follows. Although the method is described using switch 300, this is for exemplary purposes only. Any capacitive button, pad, or switch that can detect a change in capacitance and an actuation may be used. Figure 7 shows an exemplary default output of a handheld electronic device. Figure 7 may represent the main or home screen of the output of the device. For example, display 16 may represent what the device presents to the user before the user provides input to the device. Figure 8 shows an exemplary output of the device after detection of a capacitance change at capacitive switch 300, such as key 30 of Figure 1. When processor 18 receives an input indicating of a change of capacitance at key 30, for example, due to a finger touching key 30, processor 18 may cause display 16 to display window 70. Window 70 may overlap some portion of display 16 and contain one or more phone numbers 72. Phone numbers 72 may include phone numbers representing recently received phone calls, recently placed phone calls, or phone numbers in a favorites directory. Window 70 may also include a phone number marked for selection, such as phone number 74. Window 70 may indicate a phone number marked for selection by a visual indication, such as an icon located next to the phone number, a phone number displayed in a different color, or highlighting the phone number. Phone number 74 exemplifies such highlighting, but disclosed embodiments are not limited to any particular method of highlighting or any particular visual indication. Displaying window 70 may be an example of a touch function described with regard to step 625 of Figure 6.

With window 70 appearing on display 16, processor 18 may receive an indication that the user has actuated key 30, for example, by pressing down on the key. When processor 18 receives this indication, processor 18 may initiate a phone call to phone number 74 in window 70. Initiating the phone call may cause display 16 to present the display a user would see if the user had dialed the phone number manually and pressed the send key. Such a phone call initiation may involve running one or more functions in routine 22. Placing a phone call may be an example of an actuation function described with regard to step 645 of Figure 6.

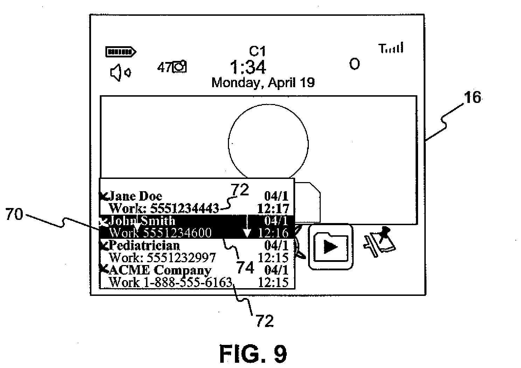

In some embodiments, a user may change the phone number marked for selection using input apparatus 8. For example, a user may actuate an up or down arrow, or rotate scroll wheel 34 located in the side of housing 6. In other embodiments, a user may change the phone number marked for selection by tapping on the capacitive switch 300 that initiated the display of the phone numbers, such as key 30 in Figure 1. For example, after processor 18 has detected a touch of key 30 and caused display 16 to present window 70, a user may tap key 30 one time. Processor 18 may receive an indication of the tap and, in response, cause the phone number marked for selection to move down one phone number, as shown in Figure 9. Additional taps on key 30 may cause the phone number marked for selection to move down to the next phone number. In this manner, a user may use key 30 to bring up window 70 and to scroll through the phone numbers displayed in window 70. In certain embodiments window 70 may remain on display 16 until a user actuates a key not used to scroll through the phone numbers or actuates the send key. Changing the phone number marked for selection in window 70 may be an example of a tap function described with regard to step 630 of Figure 6.

Another exemplary method of using a capacitive switch follows. Although the method is described using switch 300, this is for exemplary purposes only. Any capacitive button, pad, or switch that can detect a change in capacitance and an actuation may be used. Device 4 may include a camera function. A handheld electronic device could also be a camera. When a camera function is included in device 4, input apparatus 8 may include capacitive switch 300 for taking a photograph when device 4 is in camera mode. Capacitive switch 300 may be, for example, button 32 of Figure 1. When device 4 is in camera mode and the processor detects a change in capacitance at button 32 due to, for example, a user touching button 32, processor 18 may initiate an auto-focus function. The auto-focus function may be one of the functions in routine 22 and an example of step 625. Thus, the device may focus the camera lens simply in response to the user placing a finger on button 32. When the user actuates button 32, processor 18 may cause the camera to take a picture. Taking a picture may be an example of an actuation function described with regard to step 645 of Figure 6. In certain embodiments a tap of button 32 may cause processor 18 to turn a camera flash on, and a second tap may cause processor 18 to turn the camera flash off. In other embodiments, a tap may cause the camera to adjust the angle of view to zoom into the picture. Changing the camera flash mode (i.e. turning the flash on and off) and adjusting the angle of view may be examples of a tap function described in regard to step 630 of Figure 6.

As described above, it is desirable to provide an improved handheld electronic device with a capacitive switch that enables a user to more quickly access desired functions without increasing the number of keys on the keyboard, having to wade through menu selections, or requiring manufacturers to completely redesign production lines. Such a handheld electronic device might employ one more actuation keys to act as dual or triple-action switches. The keys may perform different functions depending on whether a user has a finger on the key, has tapped the key, or has actually actuated the key, but may still retain the feel of a mechanically actuated key.

While specific embodiments have been described in detail, it will be appreciated by those skilled in the art that various modifications and alternatives to those details could be developed in light of the overall teachings of the disclosure. Accordingly, the particular arrangements disclosed are meant to be illustrative only and not limiting as to the scope of the disclosed and claimed concept which is to be given the full breadth of the claims appended and any and all equivalents thereof.

## Claims

1. A multi-action capacitive switch device (300), comprising:
a surface (340) comprising a capacitive sensing area (305);
a plunger (310) comprising a conductive path (315), the conductive path (315) in contact with the capacitive sensing area (305);
a structure of flexible conductive material (320) in contact with the conductive path (315) of the plunger (310);
a capacitive touch detector (325); and
an actuation detector (330),
the structure of flexible conductive material (320) connecting with the capacitive touch detector (325) and, when the device (300) is actuated, the plunger (310) causing the structure (320) to connect with the actuation detector (330),
wherein the capacitive sensing area detects a touch and transfers a capacitance change down the conductive path (315) to the structure of flexible conductive material, and the structure transfers the capacitance change to the capacitive touch detector.

2. The device of claim 1, wherein the plunger further comprises a non-conductive material housing the conductive path (315).

3. The device of claim 1, wherein the capacitive sensing area and the conductive path (315) are comprised in a molded piece.

4. The device of claim 1, wherein the capacitive touch detector determines a duration of a touch.

5. The device of claim 1, wherein the structure has a dome configuration and wherein a ring of conductive material connects the dome to the capacitive touch detector.

6. The device of claim 1, further comprising a processor, wherein the processor receives an input from the capacitive touch detector and determines a duration of a touch.

7. A method for placing a phone call using a mobile communication device (4), the mobile communication device comprising an input apparatus (8), an output apparatus (12, 16), a memory (20), and a processor(18), wherein the input apparatus comprises a plurality of input members (28), and at least one of the input members comprises a capacitive input member (30, 300) comprising a multi-action capacitive switch device according to any preceding claim, the method comprising:
detecting, by the processor (18), a change in capacitance (605) at the capacitive input member (605); and
in response to detecting the change in capacitance, causing the output apparatus to display (70) a plurality of phone numbers (72), one of the plurality of phone numbers being marked for selection (74);
detecting, by the processor (18), an actuation of the capacitive input member (30, 300); and
in response to detecting the actuation (610), causing the mobile communication device to initiate a call to the one of the plurality of phone numbers marked for selection.

8. The method of claim 7, further comprising:
detecting a tap (620) of the capacitive input member; and
in response to detecting the tap, causing the mobile communication device to change the phone number marked for selection from the one of the plurality of phone numbers to another of the plurality of phone numbers.

9. The method of claim 7, wherein the plurality of phone numbers comprise recently called phone numbers.

10. The method of claim 7, wherein the plurality of phone numbers comprise recently received phone numbers.

11. The method of claim 7, wherein the plurality of phone numbers comprise phone numbers belonging to a predetermined group.

12. A method of taking a picture using a handheld device, the handheld device (4) comprising a camera, an input apparatus (8), an output apparatus (12, 16), a memory (20), and a processor (18), wherein the input apparatus comprises a capacitive input member comprising a multi-action capacitive switch device (300) according to any of claims 1 to 7, the method comprising:
detecting, by the processor, a change of capacitance (605) at the capacitive input member;
in response to detecting the change in capacitance, causing the camera to initiate a first function comprising an auto-focus function;
in response to detecting a tap (620) of the capacitive input member, causing the camera to perform a second function;
detecting an actuation (610) of the capacitive input member; and
in response to detecting the actuation, causing the camera to take a picture.

13. The method of claim 12, wherein the second function comprises causing the camera to turn on flash mode.

14. The method of claim 12, wherein the second function comprises causing the camera to adjust an angle of view.

## Patentansprüche

1. Kapazitive Multiaktions-Schaltvorrichtung (300), umfassend:
eine Fläche (340), die einen kapazitiven Erfassungsbereich (305) umfasst;
einen Kolben (310), der einen leitfähigen Pfad (315) umfasst, wobei der leitfähige Pfad (315) in Kontakt mit dem kapazitiven Erfassungsbereich (305) ist;
eine Struktur aus flexiblem leitfähigem Material (320) in Kontakt mit dem leitfähigen Pfad (315) des Kolbens (310);
einen kapazitiven Berührungssensor (325); und
einen Betätigungsdetektor (330),
wobei die Struktur des flexiblen leitfähigen Materials (320) sich mit dem kapazitiven Berührungssensor (325) verbindet und wenn die Vorrichtung (300) betätigt wird, bewirkt der Kolben (310), dass die Struktur (320) sich mit dem Betätigungsdetektor (330) verbindet,
wobei der kapazitive Erfassungsbereich eine Berührung erfasst und eine Kapazitätsänderung den leitfähigen Pfad (315) hinunter zur Struktur aus flexiblem leitfähigem Material überträgt, und die Struktur überträgt die Kapazitätsänderung zum kapazitiven Berührungssensor.

2. Vorrichtung nach Anspruch 1, wobei der Kolben ferner ein nicht leitfähiges Material enthält, das den leitfähigen Pfad (315) aufnimmt.

3. Vorrichtung nach Anspruch 1, wobei der kapazitive Erfassungsbereich und der leitfähige Pfad (315) in einem Formstück enthalten sind.

4. Vorrichtung nach Anspruch 1, wobei der kapazitive Berührungssensor eine Dauer einer Berührung feststellt.

5. Vorrichtung nach Anspruch 1, wobei die Struktur eine Kuppelkonfiguration hat und wobei ein Ring aus leitfähigem Material die Kuppel mit dem kapazitiven Berührungssensor verbindet.

6. Vorrichtung nach Anspruch 1, die ferner einen Prozessor umfasst, wobei der Prozessor eine Eingabe vom kapazitiven Berührungssensor empfängt und eine Dauer einer Berührung feststellt.

7. Verfahren zum Tätigen eines Telefonanrufs unter Verwendung einer mobilen Kommunikationsvorrichtung (4), wobei die mobile Kommunikationsvorrichtung ein Eingabegerät (8), ein Ausgabegerät (12, 16), einen Speicher (20) und einen Prozessor (18) enthält, wobei das Eingabegerät eine Vielzahl von Eingabeelementen (28) enthält, und mindestens eines der Eingabeelemente umfasst ein kapazitives Eingabeelement (30, 300), das eine kapazitive Multiaktions-Schaltvorrichtung nach einem der vorherigen Ansprüche enthält, wobei das Verfahren umfasst:
durch den Prozessor (18), Feststellen einer Änderung in der Kapazität (605) am kapazitiven Eingabeelement (605); und
als Reaktion auf das Feststellen der Änderung in der Kapazität, Bewirken, dass das Ausgabegerät eine Vielzahl von Telefonnummern (72) anzeigt (70), wobei eine der Vielzahl von Telefonnummern für die Auswahl (74) markiert ist;
durch den Prozessor (18), Feststellen einer Betätigung des kapazitiven Eingabeelementes (30, 300); und
als Reaktion auf das Feststellen der Betätigung (610), Bewirken, dass die mobile Kommunikationsvorrichtung einen Anruf an die eine aus der Vielzahl von Telefonnummern auslöst, die zur Auswahl markiert ist.

8. Verfahren nach Anspruch 7, ferner umfassend:
Feststellen eines Antippens (620) des kapazitiven Eingabeelementes; und
als Reaktion auf das Feststellen des Antippens, Bewirken, dass die mobile Kommunikationsvorrichtung die Telefonnummer ändert, die zur Auswahl markiert ist, von der einen aus der Vielzahl von Telefonnummern zu einer anderen aus der Vielzahl von Telefonnummern.

9. Verfahren nach Anspruch 7, wobei die Vielzahl von Telefonnummern die kürzlich angerufenen Telefonnummern umfasst.

10. Verfahren nach Anspruch 7, wobei die Vielzahl von Telefonnummern kürzlich empfangene Telefonnummern umfasst.

11. Verfahren nach Anspruch 7, wobei die Vielzahl von Telefonnummern Telefonnummern umfasst, die zu einer vorgegebenen Gruppe gehören.

12. Verfahren zum Aufnehmen eines Bildes unter Verwendung eines tragbaren Gerätes (4), das eine Kamera, eine Eingabevorrichtung (8), eine Ausgabevorrichtung (12, 16), einen Speicher (20) und einen Prozessor (18) umfasst, wobei die Eingabevorrichtung ein kapazitives Eingabeelement enthält, das eine kapazitive Multiaktions-Schaltvorrichtung (300) nach einem der Ansprüche 1 bis 7 umfasst, wobei das Verfahren umfasst:
durch den Prozessor, Feststellen einer Änderung der Kapazität (605) am kapazitiven Eingabeelement;
als Reaktion auf das Feststellen der Änderung in der Kapazität, Bewirken, dass die Kamera eine erste Funktion auslöst, die eine Autofokus-Funktion umfasst;
als Reaktion auf das Feststellen eines Antippens (620) des kapazitiven Eingabeelementes, Bewirken, dass die Kamera eine zweite Funktion ausführt;
Feststellen einer Betätigung (610) des kapazitiven Eingabeelementes; und
als Reaktion auf das Feststellen der Betätigung, Bewirken, dass die Kamera ein Bild aufnimmt.

13. Verfahren nach Anspruch 12, wobei die zweite Funktion das Bewirken umfasst, dass die Kamera den Blitzmodus einschaltet.

14. Verfahren nach Anspruch 12, wobei die zweite Funktion das Bewirken umfasst, dass die Kamera einen Sichtwinkel einstellt.

## Revendications

1. Dispositif commutateur capacitif multi-action (300), comprenant :
une surface (340) comprenant une zone de détection capacitive (305) ;
un poussoir (310) comprenant une piste conductrice (315), la piste conductrice (315) étant en contact avec la zone de détection capacitive (305) ;
une structure de matériau conducteur souple (320) en contact avec la piste conductrice (315) du poussoir (310) ;
un détecteur tactile capacitif (325) ; et
un détecteur d'actionnement (330),
la structure de matériau conducteur souple (320) se connectant au détecteur tactile capacitif (325) et, lorsque le dispositif (300) est actionné, le poussoir (310) amenant la structure (320) à se connecter au détecteur d'actionnement (330),
dans lequel la zone de détection capacitive détecte un toucher et transfère un changement de capacité le long de la piste conductrice (315) à la structure de matériau conducteur souple, et la structure transfère le changement de capacité au détecteur tactile capacitif.

2. Dispositif selon la revendication 1, dans lequel le poussoir comprend en outre un matériau non conducteur logeant la piste conductrice (315).

3. Dispositif selon la revendication 1, dans lequel la zone de détection capacitive et la piste conductrice (315) sont compris dans une pièce moulée.

4. Dispositif selon la revendication 1, dans lequel le détecteur tactile capacitif détermine une durée d'un toucher.

5. Dispositif selon la revendication 1, dans lequel la structure possède une configuration de dôme et dans lequel une bague de matériau conducteur connecte le dôme au détecteur tactile capacitif.

6. Dispositif selon la revendication 1, comprenant en outre un processeur, dans lequel le processeur reçoit une entrée à partir du détecteur tactile capacitif et détermine une durée d'un toucher.

7. Procédé pour passer un appel téléphonique à l'aide d'un dispositif de communication mobile (4), le dispositif de communication mobile comprenant un appareil d'entrée (8), un appareil de sortie (12, 16), une mémoire (20) et un processeur (18), dans lequel l'appareil d'entrée comprend une pluralité d'éléments d'entrée (28), et au moins l'un des éléments d'entrée comprend un élément d'entrée capacitif (30, 300) comprenant un dispositif commutateur capacitif multi-action selon une quelconque revendication précédente, le procédé comprenant :
la détection, par le processeur (18), d'un changement de capacité (605) au niveau de l'élément d'entrée capacitif (605) ; et
en réponse à la détection du changement de capacité, le fait d'amener l'appareil de sortie à afficher (70) une pluralité de numéros de téléphone (72), l'un de la pluralité de numéros de téléphone étant marqué pour une sélection (74) ;
la détection, par le processeur (18), d'un actionnement de l'élément d'entrée capacitif (30, 300) ; et
en réponse à la détection de l'actionnement (610), le fait d'amener le dispositif de communication mobile à initier un appel vers l'un de la pluralité de numéros de téléphone marqués pour la sélection.

8. Procédé selon la revendication 7, comprenant en outre :
la détection d'un tapotement (620) de l'élément d'entrée capacitif ; et
en réponse à la détection du tapotement, le fait d'amener le dispositif de communication mobile à changer le numéro de téléphone marqué pour la sélection de l'un de la pluralité de numéros de téléphone à un autre de la pluralité de numéros de téléphone.

9. Procédé selon la revendication 7, dans lequel la pluralité de numéros de téléphone comprend des numéros de téléphone récemment appelés.

10. Procédé selon la revendication 7, dans lequel la pluralité de numéros de téléphone comprend des numéros de téléphone récemment reçus.

11. Procédé selon la revendication 7, dans lequel la pluralité de numéros de téléphone comprend des numéros de téléphone appartenant à un groupe prédéterminé.

12. Procédé de capture d'une image à l'aide d'un dispositif portatif, le dispositif portatif (4) comprenant un appareil de prise de vues, un appareil d'entrée (8), un appareil de sortie (12, 16), une mémoire (20) et un processeur (18), dans lequel l'appareil d'entrée comprend un élément d'entrée capacitif comprenant un dispositif commutateur capacitif multi-action (300) selon l'une quelconque des revendications 1 à 7, le procédé comprenant :
la détection, par le processeur, d'un changement de capacité (605) au niveau de l'élément d'entrée capacitif ;
en réponse à la détection du changement de capacité, le fait d'amener l'appareil de prise de vues à initier une première fonction comprenant une fonction de mise au point automatique ;
en réponse à la détection d'un tapotement (620) de l'élément d'entrée capacitif, le fait d'amener l'appareil de prise de vues à réaliser une seconde fonction ;
la détection d'un actionnement (610) de l'élément d'entrée capacitif ; et
en réponse à la détection de l'actionnement, le fait d'amener l'appareil de prise de vues à capturer une image.

13. Procédé selon la revendication 12, dans lequel la seconde fonction comprend le fait d'amener l'appareil de prise de vues à activer le mode flash.

14. Procédé selon la revendication 12, dans lequel la seconde fonction comprend le fait d'amener l'appareil de prise de vues à ajuster un angle de vue.
